(19) Europäisches Patentamt
European Patent Office
Office européen des brevets

(11) EP 3 174 205 A1

(12) EUROPEAN PATENT APPLICATION

(43) Date of publication:
31.05.2017 Bulletin 2017/22

(51) Int Cl.:
H03K 17/16 (2006.01)          H03K 17/082 (2006.01)
H02M 1/00 (2007.01)

(21) Application number: 15196750.2

(22) Date of filing: 27.11.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(71) Applicant: ABB Technology Oy
00380 Helsinki (FI)

(72) Inventors:
• Saarinen, Mikko
  00380 Helsinki (FI)
• Oinonen, Markus
  00380 Helsinki (FI)

(74) Representative: Kolster Oy Ab
Salmisaarenaukio 1
00180 Helsinki (FI)

(54) **CONTROL CIRCUIT WITH FEEDBACK**

(57)      A gate drive circuit adapted to control a power semiconductor component, the gate drive circuit comprising a gate driver connectable to a positive auxiliary voltage (V+) and to a negative auxiliary voltage (V-), the gate drive circuit comprising a feedback circuit having an inductive coupling element for providing a feedback signal, wherein one end of the feedback circuit having the inductive coupling element is connected to a known reference potential and the other end of the feedback circuit is connected to the gate driver, and the inductive coupling element is inductively coupled to the main current path of the power semiconductor component for providing feedback signal to the gate driver based on the change rate of the current of the power semiconductor component for limiting the change rate of the current of the power semiconductor component.

FIG 1

**Description**

FIELD OF THE INVENTION

The present invention relates to control of power semiconductor components, and more particularly to limiting switching transients during switching of power semiconductor components.

BACKGROUND OF THE INVENTION

Power transistors, such as IGBT's and MOSFET's, are commonly used in power electronic devices as switch components. As the power transistors are used as switches, they should be able to change their state from blocking state to fully conducting state and vice versa fast to minimize the power losses during the switching.
Although the ability to switch high currents fast is a desirable property of a switch component, the rapidly increasing and decreasing currents and voltages may cause certain problems especially in connection with inductive loads where the current is forced from one component to another.
The known problematics can be explained in connection with a half bridge configuration in which two switch components with respective antiparallel freewheeling diodes are connected in series between DC link having a DC link voltage. Considering a situation in which a current flows through the lower of the switch components and it is desired to connect the positive voltage of the DC link to the load. The switch component carrying the current is turned-off by applying a suitable gate voltage and the voltage across the component increases while the current still flows through the component. Once the voltage over the lower component can forward bias the upper freewheeling diode, the current of the lower switch component decreases rapidly. As the switch transistors current slope is negative, the voltage induced in the inductance of the commutation path increase the voltage over the switch component. The maximum voltage over the switch component is a sum of the DC-link voltage $U_{DC}$, and the voltage $u_{ind}$ induced in the commutation path stray inductances $L_{stray}$.

$$u_{\max} = U_{DC} + u_{ind} = U_{DC} - L_{stray}\frac{di}{dt} \qquad (1)$$

In equation (1) the sign of the transistors di/dt during the turn-off is negative, and thus the polarity of the inductive voltage spike $u_{ind}$ is positive. Limiting the negative di/dt is especially important when turning off the transistor in overcurrent or short-circuit situation.
Furthermore, the positive current slope during the turn-on of the switch component affects the magnitude of the reverse recovery current of the complementary free-wheeling diode in a half-bridge configurations.
Reverse recovery current can be expressed by equation (2) where $Q_{rr}$ is the charge stored in the diode.

$$i_{rr} = \sqrt{Q_{rr}\frac{di}{dt}} \qquad (2)$$

Thus the current change rate has direct influence on the magnitude of the reverse recovery current and on the voltage overshoot in the above described manner. For safe operating the components in safe operating areas and for minimization of losses it is desirable to limit the change rate of the switch component current.
In order to control the transistors di/dt, the feedback signal must be obtained somehow. One method to obtain the di/dt feedback signal utilizes a small inductance in series with the transistor. The parasitic inductance between the auxiliary emitter and the power emitter of a power module can be used in this purpose, as disclosed in US 8710876 B2. The voltage over the inductance is proportional to the current time derivative, and therefore no additional differentiator circuits are needed to produce the required signal.
Using the power module parasitic inductance as a di/dt sensing element has some difficulties. Naturally there is a need for the auxiliary emitter connection to be able to use this method. The actual value of the parasitic inductance depends on power module internal layout. Thus, the inductance may vary between modules with different current ratings or different manufacturers, and every module type must be characterized separately. Typically, the parasitic inductance has also a different value in upper and lower branch in half-bridge modules. One problem is that sensing the voltage over parasitic inductance requires galvanic connection to the main circuit. This prevents to choose freely the control signal reference voltage. There is also no possibility to increase the sensitivity i.e. the value of the parasitic inductance.

BRIEF DESCRIPTION OF THE INVENTION

An object of the present invention is to provide a gate drive circuit so as to solve the above problems. The object of the invention is achieved by gate drive circuit which is characterized by what is stated in the independent claim. The preferred embodiments of the invention are disclosed in the dependent claims.

The invention is based on the idea of using inductive coupling for providing feedback from the main current path of the power semiconductor component. A feedback circuit with inductive coupling is connected to a known reference potential and the feedback circuit provides a voltage to the gate driver depending on the change rate of the current.

As the feedback circuit is not in a galvanic connection to the main circuit, the reference potential of the inductive coupling element can be chosen freely. The choice of reference potential helps in designing a simple feedback structure. Further, the sensitivity of the feedback from the current change rate can be adjusted by adjusting the number of turns in the inductive coupling element. The inductive coupling element is a coil, and preferably a Rogowski-coil or a coupled inductor.

With the invention, the switching behavior of power transistors, such as IGBT and MOSFET, can be controlled by modifying the gate voltage during switching based on the obtained feedback.

BRIEF DESCRIPTION OF THE DRAWINGS

In the following the invention will be described in greater detail by means of preferred embodiments with reference to the attached drawings, in which

Figure 1 shows a basic principle of the circuit of the present invention;
Figures 2, 3, 4 and 5 show different embodiments of the invention; and
Figure 6 show measurement results obtained with an embodiment of the invention.

DETAILED DESCRIPTION OF THE INVENTION

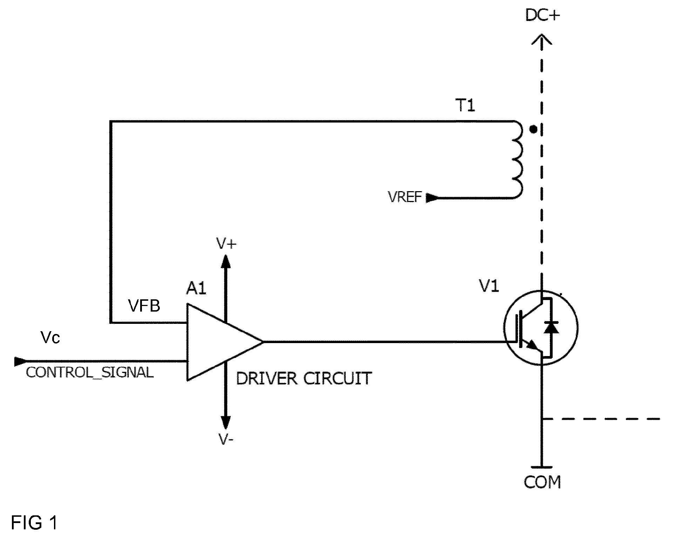

Figure 1 shows a basic structure of the gate drive circuit of the present invention. The circuit comprises a gate driver A1 which is connectable to a positive auxiliary voltage V+ and to a negative auxiliary voltage V-. The gate driver receives a control signal Vc for controlling a power semiconductor component V1. The gate drive circuit of the invention comprises a feedback circuit which comprises an inductive coupling element T1.

One end of the feedback circuit is connected to a known reference potential VREF and the other end of the feedback circuit is connected to the gate driver A1.

According to the invention, the inductive coupling element T1 is inductively coupled to the main current path of the power semiconductor component. The inductive coupling is carried out for providing feedback signal to the gate driver and the value of the feedback signal is based on the change rate of the current of the power semiconductor component.

In the circuit of Figure 1, the control signal Vc inputted to the gate driver A1 provides the ON/OFF control of the switch component V1. The gate driver amplifies the received control signal and is used for providing reliable control of the semiconductor component. The inputted control signal is amplified such that the output of the gate driver may obtain values that are between the positive and the negative auxiliary voltages. The positive and negative auxiliary voltage are referenced to potential COM which is the emitter potential of the switch component. Thus in the example of Figure 1, the gate driver is able to produce bi-polar control voltages to the gate of the controlled switch component.

In the example of Figure 1, the control signal Vc is compared with feedback voltage VFB. The operation of the circuit is such that when the control signal Vc is high, the gate driver controls positive auxiliary voltage to the gate of the controlled component. If, during the turn-on of the switch component, the current trough the switch component increases rapidly, the feedback circuit provides a positive feedback voltage to the gate driver. In case the obtained feedback voltage is higher than a certain limit, the gate driver reduces its output voltage such that the gate voltage of the component is reduced. The reduced gate voltage limits the change rate of the current through the component. Once the change rate of the current is limited, the feedback voltage decreases and the gate driver can supply full turn-on voltage to the gate of the controlled component.

The operation is similar during the turn-off process. If the decrease rate of the current is higher than a certain limit, the feedback voltage received by the gate driver is negative. The negative feedback voltage operates to increase the gate voltage and thereby to limit the decrease rate of the switched-off current through the component. Thus in the invention feedback is obtained from the current change rate di/dt. The voltage induced to the inductive coupling element, such as a Rogowski coil or coupled inductor, is linearly proportional to the derivative of the current through the component. Therefore, with the number of coil turns of the inductive component and with the selection of the reference potential VREF, the maximal allowable current change rate can be selected such that when the maximum allowable change rate is exceeded, the change rate is limited with the circuitry that is operatively connected to the gate driver of the gate drive circuit.

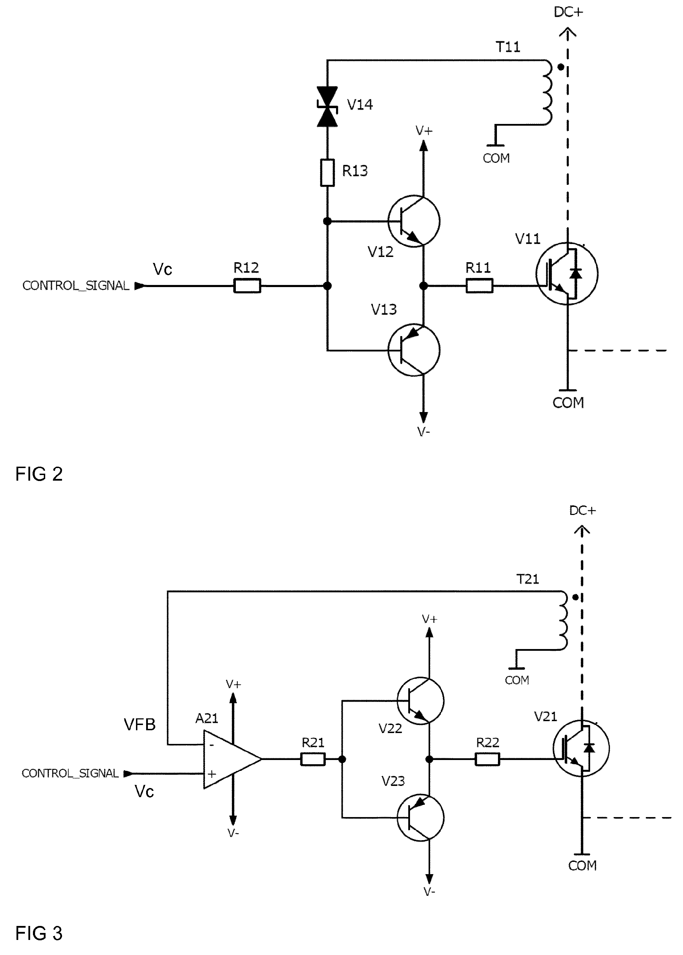

Figure 2 shows an embodiment of the invention in which the control signal is modified with the feedback from the inductive feedback element. In Figure 2 a control signal Vc is received to the gates of push-pull transistor pair V12, V13. The push-pull transistor pair is used as amplifier of the gate driver for the control signal in a manner known as such. The output of the push-pull transistor pair is connected to the gate of the controlled semiconductor component V11 through gate resistor R11.

In the circuit of Figure 2 the feedback from the current change rate is led to the base terminals of the push-pull transistor pair. More specifically, the circuit comprises a bipolar Zener diode V14 in series with the inductive coupling element and a first resistor R13 in series with the bipolar Zener diode. This feedback circuit is connected to the bases of the transistors V12, V13 forming the push-pull transistor pair. The embodiment further comprises a second resistor R12 connected between the control signal input and the bases of the transistors V12, V13.

The switch component V11 is turned on with positive voltage and the inductive feedback component, such as Rogowski coil T11, is wound in such direction, that positive di/dt of the switch component V11 causes negative voltage. The Zener voltage of the bipolar diode V14 is selected as a sum of control voltage Vc and coil voltage at maximum allowed di/dt. In this case, if the di/dt exceeds maximum allowed value, the Zener diode V14 begins to conduct thus lowering the base voltage of transistors V12 and V13 according to the voltage division between resistors R12 and R13. Thus during turn-on of the switch component and when the change rate of current exceeds a certain value, a current path is formed from the control voltage Vc through the first and second resistors R12, R13 and the Zener diode to the inductive coupling element T11, such as Rogowski coil. The current through the mentioned path lowers the potential of the base of the transistors due to the resistive voltage division between the resistors R12, R13. Due to the lower base voltage of transistor V13, it will conduct and the gate voltage of the switch component V11 is lowered thus limiting di/dt.

The circuit of Figure 2 can also be used for limiting the change rate of the current when the current is lowering. When turning the component off, the voltage induced to the inductive coupling element is positive. Once this positive voltage exceeds the sum of the zener voltage of the Zener diode V14 and the turn-off control signal Vc applied to the gates to the transistors V12, V13, the Zener diode starts conducting thus increasing the base voltage of transistors V12 and V13 according to the voltage division between resistors R12 and R13. The current flows through to the same path as in turn on in the opposite direction thus increasing base voltage of transistor V12 increasing gate voltage of the switch component V11 thus reducing negative di/dt.

Figure 3 shows another embodiment of the present invention. In this embodiment, the feedback voltage from the inductive coupling element is led to negative input of an operational amplifier A21 acting as a comparator. The control voltage Vc for controlling the switch component V21 is led to positive input of the comparator. The circuit of Figure 3 comprises similar push-pull transistor driver V22, V23 as shown in Figure 2.

When di/dt of the switch component V21 is zero, the negative input of the operational amplifier A21 is at the switch component V21 emitter potential COM, which is between the positive auxiliary voltage V+ and negative auxiliary voltage V-. The high state of the control signal is selected between switch component V21 emitter potential COM and positive auxiliary voltage V+ and the low state between the emitter potential COM and negative auxiliary voltage V-.

The high state of the control signal will increase base voltage of V22 which will conduct thus driving gate voltage of the switch component V21 high and making the switch component V21 to conduct. The low state of the control signal will drive base voltage of transistor V23 low thus driving gate voltage of the IGBT V21 low and thus stopping V21 from conducting.

The inductive coupling element, such as Rogowski coil T21, is wound in such manner, that any positive di/dt of the IGBT V21 exceeding maximum allowed value will drive A21 negative input to a value higher than the high state thus of the control voltage Vc turning IGBT V21 off until di/dt is limited below the selected value. Any negative di/dt value of the IGBT V21 exceeding selected value will drive A21 negative input to a value lower than control signal low state thus turning IGBT V21 on until di/dt is again limited below the selected value. In the embodiment, different value for maximum positive di/dt and maximum negative di/dt can be set by selecting different high state and low state values for the control signal.

In the embodiment of Figure 3 the inductive coupling element, such as Rogowski coil or coupled inductor, is used for providing feedback in the form of changing the reference voltage to which the control voltage Vc is compared. When the obtained feedback voltage VFB exceeds the value of the control voltage Vc, the output of the operational amplifier changes its state, and the gate voltage of the controlled switch component is changed to limit the current change.

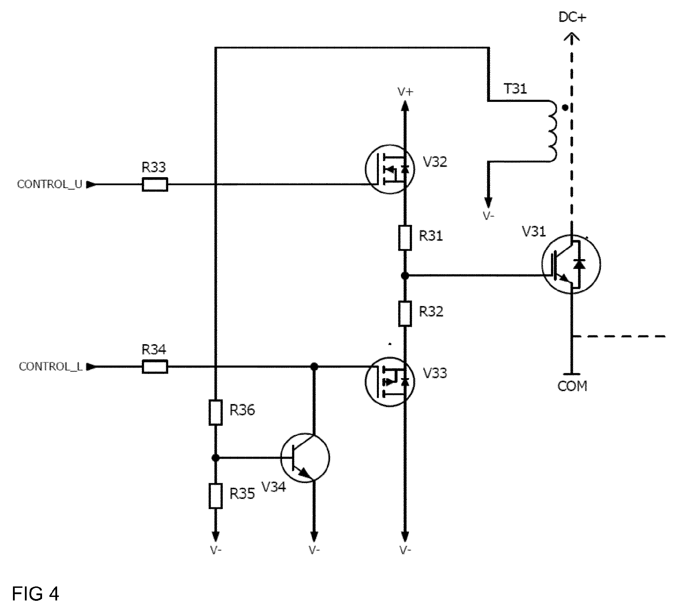

In the embodiment of Figure 4 separate control signals are used to drive the power semiconductor component, such as IGBT V31 and the gate driver comprises FET components V32, V33. When upper control signal CONTROL_U is below positive voltage supply V+, FET V32 will conduct and the IGBT V31 is controlled to conducting state. When the upper control signal CONTROL_U is at positive voltage supply V+, FET V32 will not affect IGBT V31 gate voltage.

When lower control signal CONTROL_L is at negative voltage supply V-, FET V33 will not conduct and cannot affect IGBT V31 gate voltage. When CONTROL_L is above V-, FET V33 will conduct and IGBT V31 is turned off.

In the embodiment of Figure 4, the feedback from the inductive coupling element, such as Rogowski coil T31, is used for limiting the turn-off speed of the controlled switch component V31. The feedback voltage is led to a series connection of resistors R35, R36 acting as a voltage divider. A base of a transistor V34 is connected between the resistors R35, R36. The emitter of the transistor V34 and end of the series connection of resistors are connected to the same potential, i.e. to negative auxiliary voltage V- and the collector of the transistor V34 is connected to the gate of the FET V33 which controls the turn-off of the switch component V31.

When a voltage is induced to the inductive coupling element T31 a current flows through the series connection of resistors. The first end of the inductive element is coupled to same potential as the end of the series connection of resistors. When the current from the inductive coupling element exceeds a certain limit, the base-emitter voltage of the transistor V34 rises and the transistor draws the gate of the FET V33 to a low state and thus the FET V33 blocks and turns the controlled switch component V31 OFF until the decrease rate of the current is limited below a selected value. In the embodiment of Figure 4, the inductive coupling element is wound such that negative di/dt of the IGBT V31 will cause positive voltage over the coil.

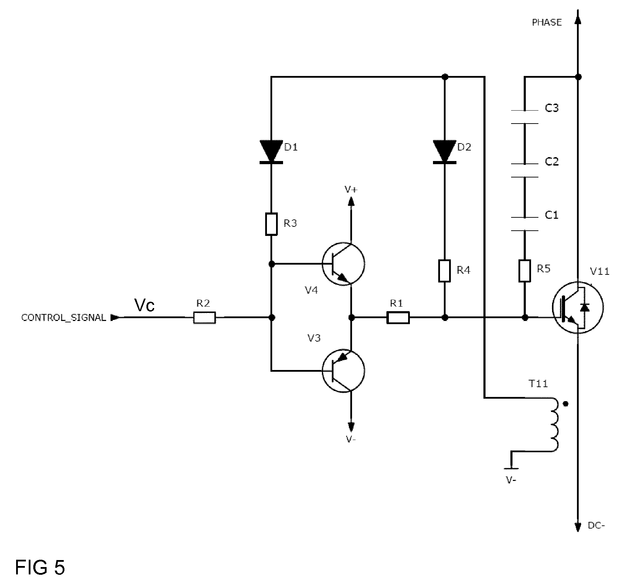

In the embodiment of Figure 5, a feedback circuit is connected to the input of push-pull transistor pair through a series connection of a diode D1 and a resistor R3. The feedback circuit corresponds to that of Figure 2, except for the Zener diode of Figure 2 is replaced with a diode in Figure 5 and the first end of the inductive coupling element T11 is connected to negative auxiliary voltage. In case of turn-off of the controlled switch component the current decrease rate is higher than a set limit, a the induced voltage will raise the potential of the input to the push-pull transistor pair V3, V4 and thereby limit the change rate of the current.

Figure 5 also shows a second feedback circuit consisting of a series connection of a diode D2 and resistor R4. This feedback loop is connected directly to the gate of the controlled component for enhancing the limiting of current change. Further, Figure 5 shows additional circuit for limiting the rate of voltage change to increase the controllability of the current change rate. The controllability of the switch component is increased by series connection of capacitors C1, C2 and C3 connected between collector and gate of the component, which slightly reduce the du/dt at turn-off by rising the gate-emitter voltage. The need for the capacitive feedback circuit depends on the used power semiconductor technology.

Although the capacitive feedback is shown in connection with a specific embodiment of the invention, the capacitive feedback is applicable to any of the presented embodiments of the invention.

It should be noted, that in any previously presented circuits, rogowski coil voltage level detection can be carry out with many different methods, for example replacing zener diodes with resistors making voltage division and vice versa.

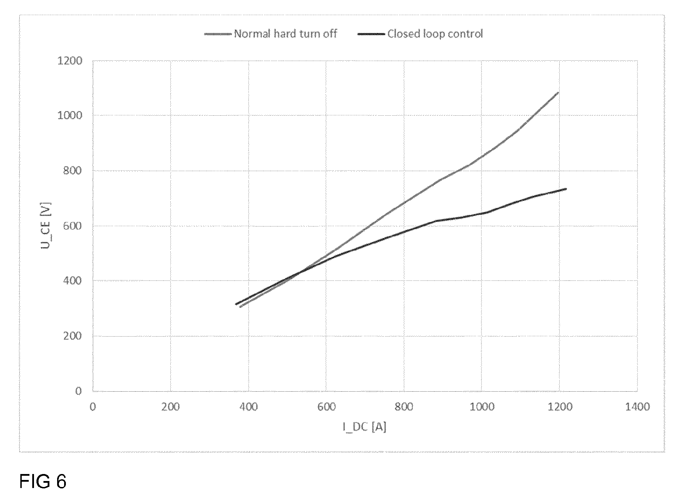

The circuit of Figure 4 was tested with Infineon FF600R12ME4 Econodual IGBT with nominal current of 600A. The nominal value for the Rogowski coil was selected to correspond turning IGBT off at 550A. The Rogowski coil was attached to the DC+ rail of the IGBT V31. In the normal hard turn off, the Rogowski coil was detached from IGBT DC+ rail. The IGBT collector current was driven to various values between 380A and 1200A and the collector-emitter voltage of the IGBT was measured. The results are shown in Figure 6, where the higher line represents measurements without the feedback and the lower line with the feedback in operation. As can be seen, the closed loop control can be used reduce IGBT collector-emitter voltage peaks thus protecting IGBT from overvoltage in case IGBT is turned off with overcurrent.

In the above, the invention is described in generally in connection with a controlled switch component. The controlled switch component or controlled semiconductor component is a power transistor, such as an IGBT or a MOSFET. Further, the generally referred inductive coupling element is preferably a Rogowski coil or a coupled inductor. The inductive coupling element is preferably situated to obtain feedback from the positive rail of the DC link. The inductive coupling element may also be situated in any other location where inductive coupling from the current of the controlled switch component is obtainable.

The gate driver circuit is further preferably used in a half-bridge configuration for controlling a switch component of the half-bridge. Preferably, each switch component has a gate driver according to the invention. Further, the half-bridge configuration may be part of a structure of a converter device.

It will be obvious to a person skilled in the art that, as the technology advances, the inventive concept can be implemented in various ways. For example, the presented Zener diodes in some of the embodiments may be replaced by voltage dividers implemented with resistors and vice versa. Further, other gate driver topologies exist in which the feedback obtained with an inductive coupling element can be used in the manner described above. The invention and its embodiments are not limited to the examples described above but may vary within the scope of the claims.

## Claims

1. A gate drive circuit adapted to control a power semiconductor component, the gate drive circuit comprising a gate driver connectable to a positive auxiliary voltage (V+) and to a negative auxiliary voltage (V-), the gate drive circuit comprising a feedback circuit having an inductive coupling element for providing a feedback signal, wherein one end of the feedback circuit having the inductive coupling element is connected to a known reference potential and the other end of the feedback circuit is connected to the gate driver, and
the inductive coupling element is inductively coupled to the main current path of the power semiconductor component for providing feedback signal to the gate driver based on the change rate of the current of the power semiconductor component for limiting the change rate of the current of the power semiconductor component.

2. A gate driver circuit according to claim 1, wherein the gate driver comprises a transistor pair forming a push-pull circuit, the output of which is connected to the gate of the power semiconductor component and the input of which is adapted to receive control voltage (Vc) for controlling the power semiconductor component, and
the feedback signal is configured to change the potential of the input of the push-pull circuit depending on the change rate of the current of the power semiconductor component.

3. A gate driver circuit according to claim 2, wherein the feedback circuit comprises a bipolar Zener diode having a Zener voltage and a first resistor (R13), the first resistor is further connected to a base of the push-pull transistor circuit, and
the gate drive circuit further comprises an input for a control voltage (Vc), the input for the control voltage being connected to the base of the push-pull transitor circuit through a second resistor (R12).

4. A gate driver circuit according to claim 2, wherein the feedback circuit is adapted provide a feedback signal to a comparator (A21), other input of the comparator receiving control voltage (Vc) for controlling the power semiconductor component, wherein on the basis of the comparison in the comparator, the state of the power semiconductor component is changed to limit the rate of change of the current.

5. A gate driver circuit according to claim 1, wherein the feedback circuit comprises a series connection of resistors (R35, R36) and a transistor (V34), the base of the transistor being connected between the resistors and the feedback signal from the inductive coupling element (T31) is adapted to turn the transistor (V34) on for changing voltage of the gate driver.

6. A gate driver circuit according to anyone of the previous claims 1 to 5, wherein the inductive coupling element is a Rogowski coil.

7. A gate driver circuit according to anyone of the previous claims 1 to 5, wherein the inductive coupling element is a coupled inductor.

8. A gate driver circuit according to anyone of the previous claims 1 to 7, wherein the inductive coupling element is inductively coupled to the DC rail of a DC link.

9. A gate driver circuit according to anyone of the previous claims 1 to 8, wherein the power semiconductor component is a power transistor, such as an IGBT or MOSFET.

10. A gate driver circuit according to anyone of the previous claims 1 to 9, wherein the gate driver circuit is adapted to control a power semiconductor component in a half-bridge configuration.

FIG 1

FIG 2

FIG 3

FIG 4

FIG 5

FIG 6

Europäisches
Patentamt

European
Patent Office

Office européen
des brevets

# EUROPEAN SEARCH REPORT

Application Number

EP 15 19 6750

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | EP 2 418 776 A1 (HONDA MOTOR CO LTD [JP]) 15 February 2012 (2012-02-15)<br>* paragraph [0074] - paragraph [0079]; figures 5,13,18a * | 1-3,5,7,9<br>10<br>4,6,8 | INV.<br>H03K17/16<br><br>ADD.<br>H03K17/082<br>H02M1/00 |
| X<br><br>A | US 8 575 974 B2 (LAITINEN MATTI [FI] ET AL) 5 November 2013 (2013-11-05)<br>* column 3, line 24 - line 67; figure 1 *<br>* column 4, line 1 - line 60 * | 1,2,4,6,9<br>3,5,7,8,10 | |
| Y<br><br>A | WO 2013/093410 A1 (AMANTYS LTD [GB]) 27 June 2013 (2013-06-27)<br>* page 3, line 13 - line 29; figure 1 *<br>* page 13, line 23 - line 25 * | 10<br><br>1-9 | |
| A | WO 2013/102778 A1 (AMERICAN POWER CONV CORP [US]; MATHIEU DENIS RENE PIERRE [FR]) 11 July 2013 (2013-07-11)<br>* figure 2 * | 1-10 | |
| A | US 7 315 439 B2 (MUENZER MARK [DE] ET AL) 1 January 2008 (2008-01-01)<br>* figure 2 * | 1-10 | TECHNICAL FIELDS SEARCHED (IPC)<br><br>H03K<br>H02M |
| A | US 6 046 516 A (MAIER REINHARD [DE] ET AL) 4 April 2000 (2000-04-04)<br>* figures 4,5 * | 1-10 | |
| A | WO 2015/070344 A1 (TM4 INC [CA]) 21 May 2015 (2015-05-21)<br>* figure 5 * | 1-10 | |

The present search report has been drawn up for all claims

| Place of search | Date of completion of the search | Examiner |
|---|---|---|
| The Hague | 11 May 2016 | O'Reilly, Siobhan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 19 6750

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2016

| Patent document cited in search report | | Publication date | Patent family member(s) | | Publication date |
|---|---|---|---|---|---|
| EP 2418776 | A1 | 15-02-2012 | CN | 102377419 A | 14-03-2012 |
| | | | EP | 2418776 A1 | 15-02-2012 |
| | | | EP | 2568604 A1 | 13-03-2013 |
| | | | US | 2012032709 A1 | 09-02-2012 |
| US 8575974 | B2 | 05-11-2013 | CN | 102655405 A | 05-09-2012 |
| | | | EP | 2495876 A1 | 05-09-2012 |
| | | | US | 2012223744 A1 | 06-09-2012 |
| WO 2013093410 | A1 | 27-06-2013 | CN | 104054264 A | 17-09-2014 |
| | | | EP | 2795797 A1 | 29-10-2014 |
| | | | GB | 2497970 A | 03-07-2013 |
| | | | JP | 2015510382 A | 02-04-2015 |
| | | | KR | 20140113990 A | 25-09-2014 |
| | | | US | 2014368240 A1 | 18-12-2014 |
| | | | WO | 2013093410 A1 | 27-06-2013 |
| WO 2013102778 | A1 | 11-07-2013 | AU | 2012364264 A1 | 10-07-2014 |
| | | | CN | 104040890 A | 10-09-2014 |
| | | | EP | 2801153 A1 | 12-11-2014 |
| | | | US | 2015042397 A1 | 12-02-2015 |
| | | | WO | 2013102778 A1 | 11-07-2013 |
| US 7315439 | B2 | 01-01-2008 | DE | 10231198 A1 | 29-01-2004 |
| | | | EP | 1520331 A1 | 06-04-2005 |
| | | | JP | 3917156 B2 | 23-05-2007 |
| | | | JP | 2005520477 A | 07-07-2005 |
| | | | US | 2004169975 A1 | 02-09-2004 |
| | | | WO | 2004008601 A1 | 22-01-2004 |
| US 6046516 | A | 04-04-2000 | AU | 8056894 A | 23-05-1996 |
| | | | EP | 0788682 A1 | 13-08-1997 |
| | | | US | 6046516 A | 04-04-2000 |
| | | | WO | 9613900 A1 | 09-05-1996 |
| WO 2015070344 | A1 | 21-05-2015 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8710876 B2